Europäisches Patentamt

European Patent Office

Office européen des brevets

(19)

(11) **EP 1 039 306 A2**

(12) **EUROPÄISCHE PATENTANMELDUNG**

(43) Veröffentlichungstag:
  **27.09.2000  Patentblatt 2000/39**

(51) Int Cl.7: **G01R 31/36**

(21) Anmeldenummer: **99122214.2**

(22) Anmeldetag: **06.11.1999**

(84) Benannte Vertragsstaaten:
  **AT BE CH CY DE DK ES FI FR GB GR IE IT LI LU MC NL PT SE**
  Benannte Erstreckungsstaaten:
  **AL LT LV MK RO SI**

(30) Priorität: **19.03.1999  DE 19912300**

(71) Anmelder: **ROBERT BOSCH GMBH**
  **70442 Stuttgart (DE)**

(72) Erfinder: **Kalkbrenner, Hans-Joachim**
  **38667 Bad Harzburg (DE)**

(54) **Verfahren zur Abschätzung der Restkapazität eines Ladungsspeichers**

(57)  Bei batteriebetriebenen Geräten mit Lithium-Zellen soll signalisiert werden, wenn ein Batteriewechsel fällig ist.

Da eine genaue Angabe der Restkapazität nur mit hohem Aufwand möglich ist, beschränkt sich das erfindungsgemäße Verfahren auf eine Abschätzung der Restkapazität mit Hilfe einer Formel.

Dabei ermittelt ein Mikroprozessor wiederholt

- die seit Inbetriebnahme des Ladungsspeichers verflossene Zeitspanne $t_A - t_0$,
- die seit Inbetriebnahme des Ladungsspeichers verflossene Betriebszeitspanne $t_{10}$ des Gerätes.

Der Mikroprozessor errechnet jeweils zu diesen ermittelten Zeitspannen die aktuelle Restkapazität $Q_R$ des Ladungsspeichers nach folgender Gleichung:

$$Q_R = Q_N - ( I_{01} + I_{00} ) \cdot (t_A - t_0 ) - ( I_{10} \cdot t_{10} ),$$

worin bedeuten:

- $Q_N$ = Nennkapazität des Ladungsspeichers,
- $I_{01}$ = Ruhestrom des Gerätes,
- $I_{00}$ = Selbstentladestrom des Ladungsspeichers,
- $I_{10}$ = Betriebsstrom des Gerätes.

Die errechnete aktuelle Restkapazität $Q_R$ vergleicht der Mikroprozessor mit einem vorgegebenen Mindestwert und veranlasst bei dessen Erreichen eine Meldung.

EP 1 039 306 A2

**Beschreibung**

Stand der Technik

Die Erfindung geht von der Gattung aus, wie im unabhängigen Anspruch 1 angegeben.

Bei batteriebetriebenen Geräten werden als Ladungsspeicher zunehmend Lithium-Zellen eingesetzt. Diese Zellen (= Batterien) haben eine höhere Spannung und Kapazität gegenüber "normalen" 1,5V-Zink-Kohle-Zellen. Soll bei Geräten mit Lithium-Zelle rechtzeitig signalisiert werden, daß die Zelle erschöpft und ein Batteriewechsel fällig ist, so ist es erforderlich, die Zustände "Voll" bis "Leer" zu erkennen. Diese Restkapazitätserkennung ist jedoch nur schwer möglich, da die Zellenspannung die einzige Meßgröße der Zelle ist, die indirekt eine Aussage über die Restkapazität der Zelle gibt. Diese Zellenspannung ist jedoch nicht nur von der Restkapazität abhängig, sondern auch von der Temperatur und dem momentanen Entladestrom der Zelle. Außerdem kündigt sich der Zustand "Leer" nicht durch ein allmähliches Absinken der Spannung an.

Daraus ergibt sich, daß eine genaue Angabe der Restkapazität nur mit hohem technischen Aufwand möglich ist, der bei kostensensitiven Geräten nicht vertretbar ist.

Vorteile der Erfindung

Der Anmeldungsgegenstand mit den Merkmalen des Anspruches 1 hat folgenden Vorteil:

Dadurch dass sich das erfindungsgemäße Verfahren auf eine Abschätzung der Restkapazität beschränkt, gelingt es, einen hohen technischen Aufwand zu vermeiden.

Die Abschätzung stützt sich auf folgende Formel für die Restkapazität $Q_r$ des Ladungsspeichers:

$$Q_r = Q_N - (I_{01} + I_{00}) \cdot (t_A - t_0) - (I_{10} \cdot t_{10})$$
$$= Q_N - Q_1 - Q_2$$

mit:

$Q_N$    Nennkapazität (auch als Elektrizitätsmenge oder Ladung der Zelle bezeichnet)

$I_{01}$    Ruhestrom des Gerätes

$I_{00}$.    Selbstentladestrom der Zelle (= Batterie)

$t_A$    Aktuelle Datum (1 Monat Genauigkeit kann genügen)

$t_0$    Anfangsdatum (Datum des Einlegens der Zelle)

$I_{10}$    Betriebsstrom des Gerätes

$t_{10}$    Betriebsdauer, die das Gerät aktiv ist

$Q_1 = (I_{01} + I_{00}) \cdot (t_A - t_0)$

$Q_2 = (I_{10} \cdot t_{10})$

Obwohl die Temperatur einen Einfluß auf die Kapazität der Zelle hat, wird sie nicht berücksichtigt.

Der Ladungsverlust $Q_1$ ergibt sich sowohl, wenn sich das Gerät im Standby-Betrieb befindet als auch wenn es aktiv ist. Der Ladungsverlust $Q_2$ ergibt sich nur, wenn das Gerät aktiv ist. Der Ladungsverlust $Q_2$ kann noch weiter unterteilt bzw. feiner aufgeschlüsselt werden, wenn berücksichtigt werden soll, dass ein Gerät nicht nur als Ganzes entweder aktiv oder inaktiv sein kann, sondern dass auch nur einige von insgesamt n Baugruppen aktiv und die restlichen inaktiv sein können. Dann setzt sich $Q_2$ aus folgenden Termen zusammen:

(Strom $I_{11}$ zum Betrieb der Baugruppe "1" ■ Dauer $t_{11}$, während

welcher die Baugruppe "1" in Betrieb ist) +

(Strom $I_{12}$ zum Betrieb der Baugruppe "2" ■ Dauer $t_{12}$, während

welcher die Baugruppe "2" in Betrieb ist) +

und so weiter.

Anders ausgedrückt für N Baugruppen::

$$Q_2 = (I_{10} \bullet t_{10}) = \sum_{n=1,2,3,.....,N} (I_{1n} \bullet t_{1n}).$$

Für den einfachsten Fall, dass das ganze Gerät als nur eine Baugruppe behandelt wird, können folgende Parameter

a) durch Messen bestimmt werden beziehungsweise
b) dem Datenblatt des Zellenherstellers entnommen und mit Hilfe des Mikrokontrollers verarbeitet werden:

zu a)

$I_{01}$     Ruhestrom des Gerätes
$t_0$     Anfangsdatum (Datum des Einlegens der Zelle)
$I_{10}$     Betriebsstrom des Gerätes
$t_{10}$     Betriebsdauer, die das Gerät aktiv ist
$t_A$     Aktuelles Datum (1 Monat Genauigkeit kann genügen)

zu b)

$Q_N$     Nennkapazität
$I_{00}$     Selbstentladestrom der Zelle

Für die Abschätzung sollten folgende Komponenten bereits in dem Gerät vorhanden sein, um die Kosten nicht zu erhöhen: Mikrokontroller mit nichtflüchtigem RAM-Speicher für Daten und ROM-Speicher für die zusätzlichen Softwareroutinen.
Vorteilhafte Weiterbildungen sind in den abhängigen Ansprüchen angegeben, deren Merkmale auch, soweit sinnvoll, miteinander kombiniert werden können.
Bevorzugtes Anwendungsgebiet für die Erfindung ist eine sogenannte On Board Unit (OBU), die der automatischen Gebührenerfassung (Autobahngebühr) dient. Dieses Gerät wird in einem Auto mitgeführt und permanent von einer Lithium-Zelle versorgt. Es wird aktiv, sobald der Benutzer eine Taste betätigt oder eine ,,Zahlstelle" passiert wird. Bei einer solchen OBU soll akustisch oder auf einem Display oder durch eine LED der Zustand (Restkapazität) der versorgenden Zelle (oder zumindest das Erreichen einer Mindestrestkapazität) gemeldet werden, damit der Endverbraucher rechtzeitig die Zelle wechseln kann.
Im Fall der OBU wird $t_0$ beim Endtest in der Fertigung oder nach erfolgtem Batteriewechsel durch den Kundendienst dem Gerät per Funk übermittelt. Wechselt der Endverbraucher die Zelle selbst, so wird das Datum erst beim Durchfahren einer Zahlstelle dem Gerät mitgeteilt. $t_A$ wird bei jedem Durchfahren einer Zahlstelle dem Gerät mitgeteilt und aktualisiert. $t_{10}$ wird durch den Mikrokontroller ermittelt.
Da ein Batteriewechsel nur selten durchgeführt wird oder nur durch Fachpersonal erfolgt, ist davon auszugehen, dass nur neue Zellen eingesetzt werden. Wird nämlich eine verbrauchte Batterie in das Gerät eingesetzt, so wird fälschlicherweise der Zustand "Voll" signalisiert. Ist dies nicht akzeptabel, so muss die Spannung vor und nach dem Batteriewechsel gemessen werden. (Der eingesetzte Mikrokontroller bei der OBU kann Spannungen messen). Sind beide Meßwerte identisch, oder ist die Spannung nach dem Wechsel sogar geringer, so wurde eine alte Zelle eingesetzt. Ist die gemessene Spannung nach einem Wechsel höher (oder übersteigt sie einen vorher definierten Referenzspannungswert), so kann davon ausgegangen werden, dass eine neue Zelle eingesetzt wurde. Für den Batteriewechsel wird ein FlipFlop als Speicher für die "alte" Batteriespannung oder ein Flag im **nicht** flüchtigen Datenspeicher vorgesehen, da die Betriebsspannung während des Wechsels nicht vorhanden ist.

**Patentansprüche**

**1.** Verfahren zur Meldung, wenn die Restkapazität eines elektrischen Ladungsspeichers in einem Gerät einen vorgegebenen Mindestwert erreicht,
dadurch gekennzeichnet,

dass ein Mikroprozessor wiederholt Folgendes ermittelt:

- die seit Inbetriebnahme des Ladungsspeichers verflossene Zeitspanne $t_A - t_0$,
- die seit Inbetriebnahme des Ladungsspeichers verflossene Betriebszeitspanne $t_{10}$ des Gerätes,

dass der Mikroprozessor jeweils zu diesen ermittelten Zeitspannen die aktuelle Restkapazität $Q_R$ des Ladungsspeichers nach folgender Gleichung errechnet:

$$Q_R = Q_N - ( I_{01} + I_{00} ) \blacksquare (t_A - t_0 ) - ( I_{10} \blacksquare t_{10} ),$$

worin bedeuten:

$Q_N$ = Nennkapazität des Ladungsspeichers,
$I_{01}$ = Ruhestrom des Gerätes,
$I_{00}$ = Selbstentladestrom des Ladungsspeichers,
$I_{10}$ = Betriebsstrom des Gerätes,
$t_A$ = Aktueller Zeitpunkt oder aktuelles Datum,
$t_0$ = Anfangszeitpunkt oder Anfangsdatum der Inbetriebnahme des Ladungsspeichers,

dass der Mikroprozessor die errechnete aktuelle Restkapazität $Q_R$ mit dem vorgegebenen Mindestwert vergleicht und bei dessen Erreichen die Meldung veranlasst.

2. Verfahren nach Anspruch 1, dadurch gekennzeichnet, dass zur Berechnung der aktuellen Restkapazität $Q_R$ mindestens einer der Stromwerte $I_{01}$, $I_{00}$ , $I_{10}$ aus einem Speicher des Gerätes ausgelesen wird.

3. Verfahren nach Anspruch 1, dadurch gekennzeichnet, dass zur Berechnung der aktuellen Restkapazität $Q_R$ mindestens einer der Stromwerte $I_{01}$, $I_{00}$ , $I_{10}$ gemessen wird.

4. Verfahren nach einem der vorangehenden Ansprüche, dadurch gekennzeichnet, dass die seit Inbetriebnahme des Ladungsspeichers verflossene Zeitspanne $t_A - t_0$ von dem Mikroprozessor aus der Differenz zwischen dem aktuellen Datum ($t_A$) und einem Anfangsdatum $t_0$ ermittelt wird.

5. Verfahren nach Anspruch 4, dadurch gekennzeichnet, dass das Anfangsdatum $t_0$ bei der Fertigung des Gerätes in einen Speicher des Gerätes eingespeichert und bei der Berechnung der aktuellen Restkapazität $Q_R$ aus dem Speicher ausgelesen wird.

6. Verfahren nach Anspruch 4, dadurch gekennzeichnet, dass das Anfangsdatum ($t_0$) nach erfolgtem Auswechseln des Ladungsspeichers durch einen Kundendienst in das Gerät eingespeichert wird.

7. Verfahren nach Anspruch 4 oder 6, dadurch gekennzeichnet, dass das Anfangsdatum ($t_0$) dem Gerät per Funk übermittelt wird.

8. Verfahren nach Anspruch 4 oder 6, dadurch gekennzeichnet, dass das Gerät ein Mobilgerät eines Mautsystems ist und das Anfangsdatum $t_0$ dem Gerät beim erstmaligen Passieren einer Zahlstelle nach dem Auswechseln des Ladungsspeichers per Funk übermittelt wird.

9. Verfahren nach Anspruch 4, dadurch gekennzeichnet, dass das Gerät ein Mobilgerät eines Mautsystems ist und das aktuelle Datum $t_A$ jeweils beim Passieren einer Zahlstelle per Funk übermittelt wird.

10. Verfahren nach einem der vorangehenden Ansprüche, dadurch gekennzeichnet,

- dass die Spannung am auszuwechselnden Ladungsspeicher gespeichert und nach dem Auswechseln mit der Spannung am neuen Ladungsspeicher verglichen wird und
- dass ein Vergleichsergebnis gemeldet wird.

11. Verfahren nach einem der Ansprüche 1 bis 9, dadurch gekennzeichnet,

- dass eine vorgegebene Referenzspannung nach dem Auswechseln des Ladungsspeichers mit der Spannung am neuen Ladungsspeicher verglichen wird und
- dass ein Vergleichsergebnis gemeldet wird.

12. Verfahren nach einem der vorangehenden Ansprüche, dadurch gekennzeichnet, dass bei einem Gerät mit einer Anzahl von N Baugruppen der Term ($I_{10} \blacksquare t_{10}$) gleich

$$\sum_{n=1,2,3,\ldots,N} (I_{1n} \blacksquare t_{1n}) \quad \text{ist}$$

mit

$I_{1n} =$     Betriebsstrom der n-ten Baugruppe,
$t_{1n} =$     Betriebszeitspanne der n-ten Baugruppe.